**Europäisches Patentamt**

**European Patent Office**

**Office européen des brevets**

(19)

(11) Veröffentlichungsnummer: **0 051 172**
**B1**

(12) **EUROPÄISCHE PATENTSCHRIFT**

(45) Veröffentlichungstag der Patentschrift:
**11.07.84**

(21) Anmeldenummer: **81108239.5**

(22) Anmeldetag: **12.10.81**

(51) Int. Cl.³: **H 01 L 33/00,** H 01 L 29/46,
G 02 B 5/08

(54) **Ohmscher Kontakt auf einem lichtdurchlässigen Substrat eines Bauelements.**

(30) Priorität: **03.11.80 DE 3041358**

(43) Veröffentlichungstag der Anmeldung:
**12.05.82 Patentblatt 82/19**

(45) Bekanntmachung des Hinweises auf die Patenterteilung:
**11.07.84 Patentblatt 84/28**

(84) Benannte Vertragsstaaten:
**DE FR GB IT**

(56) Entgegenhaltungen:
**DE - A - 2 702 935**
**DE - B - 2 045 106**
**DE - B - 2 445 763**
**US - A - 3 931 631**

**IEEE TRANSACTIONS ON ELECTRON DEVICES,**
**Oktober 1976, New York HEINEN, WESTERMEIER,**
**HARTH, ZSCHAUER: "Proton Bombarded GaA1As:**
**GaAs Light Emitting Diodes" Seite 1186**

(73) Patentinhaber: **SIEMENS AKTIENGESELLSCHAFT,**
**Berlin und München Wittelsbacherplatz 2,**
**D-8000 München 2 (DE)**

(72) Erfinder: **Aengenheister, Jörg, Dipl.-Phys., Münchner**
**Kindl Weg 22, D-8000 München 90 (DE)**
Erfinder: **Bacs, Laszlo, Ammerseestrasse 30,**
**D-8021 Neuried (DE)**

## Beschreibung

Die Erfindung betrifft einen ohmschen Kontakt für Bauelemente, insbesondere Halbleiterbauelemente, bestehend aus einer Schichtenfolge einschliesslich Gold auf einem lichtdurchlässigen Substrat; ein derartiges Bauelement ist aus DE-A Nr. 2702935 bekannt.

Für den Wirkungsgrad von Lumineszenzdioden mit transparenten Substraten ist die Lichtreflexion an der Rückseite des Substrats von grosser Bedeutung. Auf dieser Rückseite befindet sich gewöhnlich ein elektrischer Kontakt für die Stromzuführung zu einer Zone des einen Leitfähigkeitstyps des Substrats. Dieser Kontakt ist aber stark lichtabsorbierend, wenn er die gewünschten elektrischen Eigenschaften, nämlich einen niedrigen ohmschen Widerstand, hat. Um diese Lichtabsorption zu vermeiden, wird bisher die Rückseite des Substrats daher nur teilweise mit einem ohmschen Kontakt versehen. Durch die geringere Kontaktfläche werden aber insbesondere die elektrischen Eigenschaften beeinträchtigt, d. h., am Übergang zwischen dem Kontakt und dem Substrat liegt ein Widerstand mit einer oft unerwünschten Höhe vor. Ausserdem verringert sich durch die kleinere Kontaktfläche die Haltbarkeit des Kontakts am Substrat.

Es ist daher Aufgabe der Erfindung, einen lichtreflektierenden ohmschen Kontakt anzugeben, der bei hoher Lichtreflexion die gewünschten elektrischen Eigenschaften, also einen niedrigen ohmschen Widerstand, aufweisen soll.

Diese Aufgabe wird bei einem lichtreflektierenden ohmschen Kontakt der eingangs genannten Art erfindungsgemäss dadurch gelöst, dass die Schichtenfolge an der Rückseite des Substrats lichtreflektierend ist und eine erste Schicht aus Gold und Germanium im Gewichtsverhältnis etwa 99:1, eine zweite Schicht aus reinstem Silber und eine dritte Schicht aus reinstem Gold aufweist.

In vorteilhafter Weise ist die erste Schicht etwa 0,02 µm (200 Å), die zweite Schicht 0,8 µm und die dritte Schicht 0,5 µm dick. Ein derartiger Kontakt ist insbesondere für Lumineszenzdioden vorteilhaft. Er ist aber auch dann anwendbar, wenn ein Substrat mit einer lichtreflektierenden Schicht kontaktiert werden soll.

In vorteilhafter Weise wird dieser Kontakt so hergestellt, dass die einzelnen Schichten auf die Rückseite des Substrats aufgedampft und anschliessend dort angesintert werden. Der so hergestellte ohmsche Kontakt weist bei einem niedrigen ohmschen Widerstand eine hervorragende Lichtreflexion auf.

Nachfolgend wird die Erfindung an Hand der Zeichnung näher erläutert. Es zeigen:

Fig. 1 eine Leuchtdiode im Schnitt, und

Fig. 2 die Schichtenfolge des erfindungsgemässen Kontakts.

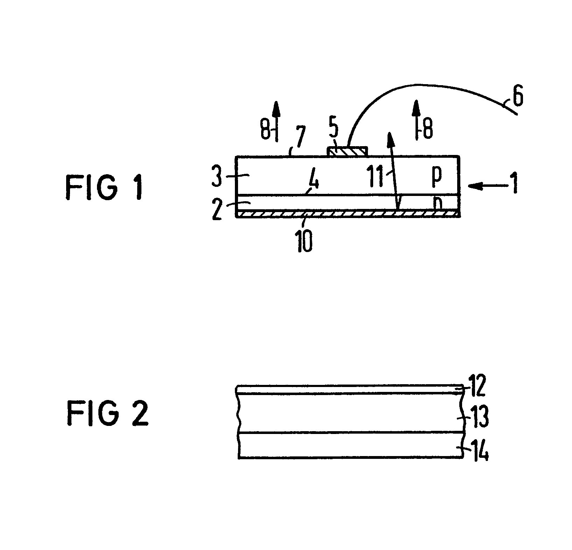

In der Fig. 1 besteht ein Halbleitersubstrat 1 aus einer n-leitenden Zone 2 und einer p-leitenden Zone 3, die durch einen pn-Übergang 4 voneinander getrennt sind. Auf der Zone 3 ist ein Kontakt 5 angebracht, der mit einem Draht 6 als Zuleitung verbunden ist. Von der Oberfläche 7 dieser Zone 3 wird Licht abgestrahlt, wie dies durch Pfeile 8 angedeutet ist. Das Substrat 1 ist lichtdurchlässig. Um einen hohen Wirkungsgrad zu erzielen, sollte das im Substrat 1 und vorzugsweise am pn-Übergang erzeugte Licht von der Rückseite des Substrats 1 bzw. der Zone 2 reflektiert werden und so über die Oberfläche 7 das Substrat 1 verlassen. Hierzu ist der auf der Rückseite des Substrats 1 vorgesehene Kontakt 10 lichtreflektierend ausgestaltet, so dass dort das im Inneren des Substrats 1 erzeugte Licht reflektiert wird, wie dies durch einen Pfeil 11 angedeutet ist.

Dieser Kontakt 10 besteht aus einer Schichtenfolge (vgl. Fig. 2) mit einer ersten −0,02 µm dicken Schicht 12 aus Gold und Germanium im Gewichtsverhältnis etwa 99:1 − einer zweiten − 0,8 µm dicken Schicht 13 aus reinstem Silber − und einer dritten − 0,5 µm dicken Schicht 14 aus reinstem Gold. Die Schicht 12 befindet sich dabei auf der Oberfläche der Zone 2.

Die einzelnen Schichten werden ganzflächig auf die Oberfläche der Zone 2 nacheinander aufgedampft. Anschliessend werden diese Schichten gesintert. Der so hergestellte Kontakt hat die gewünschten Eigenschaften einer hohen Lichtreflexion und eines niedrigen ohmschen Widerstands.

## Patentansprüche

1. Ohmscher Kontakt für Bauelemente, insbesondere Halbleiterbauelemente, bestehend aus einer Schichtenfolge einschliesslich Gold auf einem lichtdurchlässigen Substrat, dadurch gekennzeichnet, dass die Schichtenfolge an der Rückseite des Substrats lichtreflektierend ist und eine erste Schicht (12) aus Gold und Germanium im Gewichtsverhältnis etwa 99:1, eine zweite Schicht (13) aus reinstem Silber und eine dritte Schicht (14) aus reinstem Gold aufweist.

2. Kontakt nach Anspruch 1, dadurch gekennzeichnet, dass die erste Schicht (12) etwa 0,02 µm (200 Å), die zweite Schicht (13) 0,8 µm und die dritte Schicht (14) 0,5 µm dick ist.

3. Verwendung des Kontakts nach einem der beiden Ansprüche 1 oder 2 für Lumineszenzdioden (1).

4. Verfahren zur Herstellung des Kontakts nach einem der beiden Ansprüche 1 oder 2, dadurch gekennzeichnet, dass die einzelnen Schichten (12, 13, 14) auf die Rückseite des Substrats (1) aufgedampft und anschliessend angesintert werden.

## Claims

1. An ohmic contact for components, in particular semiconductor components, consisting of a sequence of layers, including gold, on a transparent substrate, characterised in that on the rear face of the substrate, the layer sequence is light-reflecting and has a first layer (12) of gold and germanium in a ratio by weight of approximately 99:1, a second layer (13) of purest silver, and a third layer (14) of purest gold.

2. A contact according to Claim 1, characterised in that the first layer (12) has a thickness of approximately 0.02 µm (200 Å), the second layer (13) has a thickness of 0.8 µm, and the third layer (14) has a thickness of 0.5 µm.

3. The use of the contact according to Claim 1 or 2 for luminescent diodes (1).

4. A process for the production of the contact according to Claim 1 or 2, characterised in that the individual layers (12, 13, 14) are vapour-deposited onto the rear of the substrate (1), and subsequently sintered.

## Revendications

1. Contact ohmique pour des composants, notamment des composants à semi-conducteurs, qui est constitué par une succession de couches incluant de l'or, sur un substrat transparent, caractérisé par le fait que la succession de couches sur la face arrière du substrat est réfléchissante pour la lumière et comprend une première couche (12) formée d'or et de germanium, dans un rapport pondéral égal approximativement à 99:1, une seconde couche (13) constituée par de l'argent extrêmement pur et une troisième couche (14) constituée par de l'or extrêmement pur.

2. Contact suivant la revendication 1, caractérisé par le fait que la première couche (13) possède une épaisseur égale à environ 0,02 µm (200 Å), la seconde couche (13) une épaisseur de 0,8 µm et la troisième couche (14) une épaisseur de 0,5 µm.

3. Utilisation du contact suivant l'une des revendications 1 ou 2 pour des diodes à luminescence (1).

4. Procédé pour fabriquer le contact suivant l'une des revendications 1 ou 2, caractérisé par le fait qu'on dépose par évaporation les différentes couches (12, 13, 14) sur la face arrière du substrat (1) et qu'on en effectue ensuite le frittage.

FIG 1

FIG 2